# EUROPEAN PATENT APPLICATION

(11) **EP 4 815 298 A1**
(43) Date of publication of application: **30.09.2026**
(21) Application number: 26162091.8
(22) Date of filing: 03.03.2026
(51) Int. Cl.: H03F 1/26, H03F 3/343, H03F 3/345, H03F 3/347, H03F 3/45

(54) **LOW NOISE LOW CURRENT BIAS AMPLIFIER TOPOLOGY**

(30) Priority: 25.03.2025 US 202563777141 P
(71) Applicant: Analog Devices, Inc., Wilmington, MA 01887 (US)
(72) Inventor: NIEMANN, James Alan, Wilmington, 01887 (US)
(74) Representative: Wallin, Nicholas James

(57) **Abstract**

A controlling amplifier may be configured to produce an amplified signal from an input signal and may have one input terminal configured to receive the input signal, another input terminal coupled to a zero current node, and an output terminal configured to output the amplified signal. A zero current circuit may be coupled to the zero current node, may comprise at least one capacitor comprising a first terminal coupled to the zero current node, and may be configured to force voltages across each at least one capacitor to zero. Some embodiments may include a servo amplifier circuit comprising a servo amplifier and a feedback, and the servo amplifier may have one input terminal coupled to the output terminal of the controlling amplifier and may have the feedback coupled between its other input terminal and its output terminal.

## Description

### BACKGROUND

Most amplifier designs use complimentary metal-oxide-semiconductor (CMOS), bipolar amplifier (e.g., bipolar junction transistor (BJT)), or junction field-effect transistor (JFET) elements to amplify a signal. Each of these choices involves a trade-off for minimizing noise. To minimize voltage noise, a bipolar amplifier may be best. To minimize bias current (ibias) and current noise, the JFET may be the better choice.

Some examples of known ways to design low noise and current bias amplifiers include the following. A low noise bipolar amplifier using superbeta transistors could achieve a relatively low ibias for a bipolar amplifier. A large geometry (high gm) JFET amplifier could minimize the broad band JFET noise (related to 1/gm). Using many bipolar or JFET amplifiers in parallel could reduce the noise by sqrt(number of amplifiers). Using bandwidth limiting/control techniques could limit the noise (e.g., lockin/chopper/autozero techniques). These techniques are generally large, complex, and/or costly and do not necessarily deliver desired noise and ibias characteristics.

### BRIEF DESCRIPTIONS OF THE DRAWINGS

FIG. 1 shows example circuit diagrams of prior art amplifier circuits.
FIG. 2 shows an example circuit diagram of an amplifier circuit with noise and ibias reduction features according to some embodiments of the disclosure.
FIG. 3 shows an example circuit diagram of an inverting amplifier circuit with noise and ibias reduction features including servo circuitry according to some embodiments of the disclosure.
FIG. 4 shows an example circuit diagram of an inverting amplifier circuit with noise and ibias reduction features including nested servo circuitry according to some embodiments of the disclosure.
FIG. 5 shows an example circuit diagram of an amplifier circuit with noise and ibias reduction features including servo circuitry according to some embodiments of the disclosure.
FIG. 6 shows an example circuit diagram of an amplifier circuit with noise and ibias reduction features including nested servo circuitry according to some embodiments of the disclosure.
FIG. 7 shows an example circuit diagram of an amplifier circuit with noise and ibias reduction features including nested servo circuitry according to some embodiments of the disclosure.
FIG. 8 shows an example circuit diagram of an amplifier circuit with noise and ibias reduction features including nested servo circuitry according to some embodiments of the disclosure.
FIG. 9 shows an example circuit diagram of an amplifier circuit with noise and ibias reduction features including nested servo circuitry according to some embodiments of the disclosure.
FIG. 10 shows an example noise curve for the circuit of FIG. 7 according to some embodiments of the disclosure.
FIG. 11 shows an example noise curve for the circuit of FIG. 8 according to some embodiments of the disclosure.
FIG. 12 shows an example noise curve for the circuit of FIG. 9 according to some embodiments of the disclosure.

### DETAILED DESCRIPTION OF SEVERAL EMBODIMENTS

Systems and methods described herein can provide architecture combining the advantages of each legacy amplifier design. For example, disclosed circuits may have the low ibias current of a JFET or CMOS amplifier or other low current device and the broad band noise characteristics of a bipolar amplifier or other low noise device. For example, embodiments may provide arrangements that enable low noise bipolar amplifiers to be used in a circuit in a way that also achieves low bias current, effectively providing amplifiers with JFET levels of ibias and voltage noise characteristics of the best bipolar amplifiers.

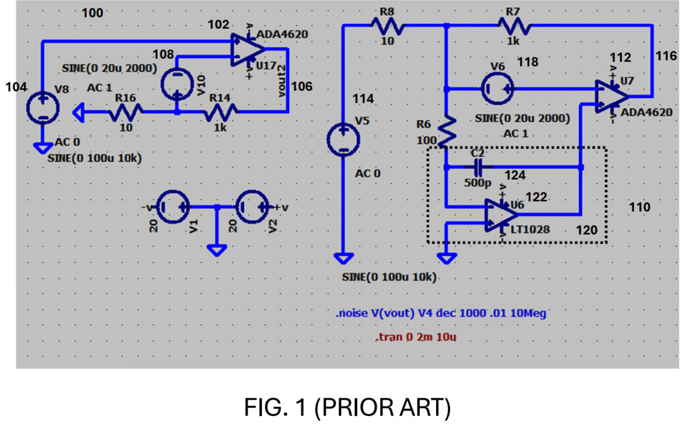

FIG. 1 shows example circuit diagrams of prior art amplifier circuits 100, 110. For example, amplifier circuit 100 includes amplifier 102 having a first input terminal coupled to source 104 (Vin), a second input terminal coupled to ground through a resistor network, and an output terminal providing amplified signal 106 (Vout). This amplifier circuit 100 is a non-inverting amplifier circuit. A noise 108 component is illustrated, demonstrating a typical problem with amplifier circuit 100, namely that noise 108 on amplifier 102 input(s) can alter the characteristics of the amplified signal 106 to be meaningfully different from what an ideal amplified version of the input signal from source 104 would be. In amplifier circuit 100, the output of amplifier 102 will have the noise and ibias inherent to the selected amplifier 102 (here, an ADA4620 JFET op-amp shown as an example, although it will be understood that other selections may be used for amplifier 102).

Amplifier circuit 110 is different from amplifier circuit 100 in that amplifier circuit 110 is an inverting amplifier circuit and adds a servo amplifier circuit 120. For example, amplifier circuit 110 includes amplifier 112 having a first input terminal coupled to source 114 (Vin) through one or more resistor elements, a second input terminal coupled to ground through servo amplifier circuit 120, and an output terminal providing amplified signal 116 (Vout). Again, an ADA2620 JFET op-amp is used as an example for amplifier 112, although other selections are possible. The polarities of the first and second input terminals are reversed relative to amplifier circuit 110, making this an inverting amplifier circuit. A noise component 118 is included, again demonstrating the noise problem which is also present for amplifier circuit 110. Noise characteristics are partially improved by servo amplifier circuit 120, which includes servo amplifier 122 (here, an LT1028 low noise op-amp shown as an example, although it will be understood that other selections may be used for servo amplifier 122) having one input terminal coupled to ground, and the output terminal coupled to the second input terminal of amplifier 112 and fed back to the other input terminal of servo amplifier 122 through feedback 124 (e.g., a capacitor). The servo amplifier circuit 120 can lower the noise entering the second terminal of amplifier 112 and thus improve output response to some degree, for example by correcting offset and/or other noise lower than the time constant C2/R6. However, it can be readily seen that noise component 118 is still contributing to alter the characteristics of the amplified signal 116 to be meaningfully different from what an ideal amplified version of the input signal from source 114 would be.

The systems and methods described herein may provide improved noise and ibias correction to amplifier circuits. Example architecture may incorporate bipolar amplifiers selected for good noise characteristics (not necessarily for ibias characteristics) and JFET amplifiers selected for good ibias characteristics (not necessarily for noise characteristics). Bipolar and JFET amplifiers are used as examples in the illustrations herein, but it should be understood that some embodiments may use other low noise devices in place of a bipolar amplifier, and some embodiments may use other low current devices in place of a JFET amplifier. It should also be understood that R values, C values, signal values, and/or other values present in the drawings are examples and may vary for other embodiments. The arrangements described herein may drive the voltage gradients from an input terminal to the outside world to zero or near zero.

For example, at least some embodiments may use a servo amplifier broadband to reduce the overall system noise. At least some embodiments may reduce the voltage variation or movement in voltage due to a changing input signal. At least some embodiments may include nested servo amplifiers to drive the resulting voltage movement at an isolating capacitance to zero, resulting in JFET levels of ibias current for a low noise bipolar amplifier. At least some embodiments may force all voltages across all dielectrics from input high to any ground reference circuit to zero.

Some embodiments described herein may include a controlling amplifier configured to produce an amplified signal from an input signal. The controlling amplifier may include a first controlling amplifier input terminal configured to receive the input signal, a second controlling amplifier input terminal coupled to a zero current node, and a controlling amplifier output terminal configured to output the amplified signal. In at least some embodiments, the controlling amplifier may be a bipolar amplifier.

Some embodiments described herein may include a zero current circuit coupled to the zero current node. The zero current circuit may be configured to force voltages across each at least one capacitor to zero. The zero current circuit may include at least one capacitor with a first terminal coupled to the zero current node, at least one resistor comprising a first terminal coupled to the zero current node, and a zero current circuit amplifier. The zero current circuit amplifier may include a zero current circuit amplifier output coupled to a second terminal of the at least one resistor and configured to present zero volts across a series combination of the at least one resistor and the at least one capacitor. In at least some embodiments, the zero current circuit amplifier may be a field effect transistor amplifier. In at least some embodiments, a resistance of the at least one resistor and a capacitance of the at least one capacitor may be selected to provide a current path away from the zero current node through the at least one resistor for at least one frequency of the input signal.

Some embodiments described herein may include a servo amplifier circuit. The servo amplifier circuit may include a servo amplifier and a feedback. The servo amplifier may include a first servo amplifier input terminal coupled to the controlling amplifier output terminal, a second servo amplifier input terminal, and a servo amplifier output terminal. In at least some embodiments, the servo amplifier may be a field effect transistor amplifier. In at least some embodiments, the feedback may be coupled to the second servo amplifier input terminal and the servo amplifier output terminal.

In some embodiments, the servo amplifier circuit may be a nested circuit further including a nesting servo amplifier and a second feedback. The nesting servo amplifier may include a first nesting servo amplifier input terminal coupled to the servo amplifier output terminal, a second nesting servo amplifier input terminal, and a nesting servo amplifier output terminal. The second feedback may be coupled to the second nesting servo amplifier input terminal and the nesting servo amplifier output terminal. In at least some embodiments, the nesting servo amplifier may be a field effect transistor amplifier.

In some embodiments, the nested circuit may further include an additional nesting servo amplifier and a third feedback. The additional nesting servo amplifier may include a first additional nesting servo amplifier input terminal coupled to the nesting servo amplifier output terminal, a second additional nesting servo amplifier input terminal, and an additional nesting servo amplifier output terminal. The third feedback may be coupled to the second additional nesting servo amplifier input terminal and the additional nesting servo amplifier output terminal. The additional nesting servo amplifier may include a field effect transistor amplifier.

In some embodiments, the servo amplifier may operate at a first frequency, the nesting servo amplifier may operate at a second frequency lower than the first frequency, and/or the additional nesting servo amplifier may operate at a third frequency lower than the second frequency.

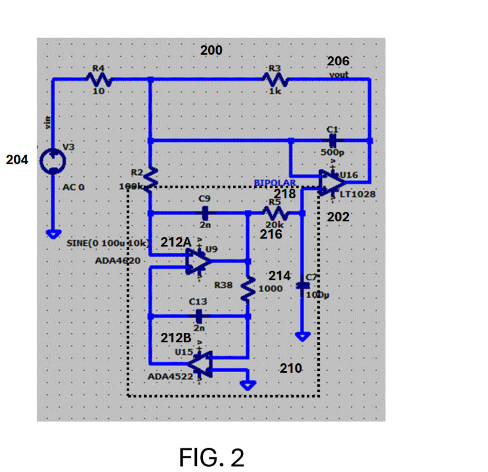

FIGS. 2-9 show examples of amplifier circuits incorporating some or all of the above features. As described in detail below, the example circuits may have different specific configurations and/or options, but each illustrated circuit provides improved noise and ibias reduction through incorporation of one or more of the above features. For example, input voltage may have several terms, such as AC or DC noise voltage (such as amplifier noise) that is present from input HI to any ground referenced circuit (Ibias =V/Z), input bias current of the bipolar amplifier (a current source) which may split based on all impedances presented to the input of the amplifier, and/or AC or DC signal voltage that is presented from input HI to any ground referenced circuit from the input signal source. The amplifier circuits described below may reduce or eliminate noise caused by one or more of these terms.

FIG. 2 shows an example circuit diagram of an inverting amplifier circuit 200 with noise and ibias reduction features according to some embodiments of the disclosure. Circuit 200 may include controlling amplifier 202 having a first input terminal coupled to source 204 (Vin) through one or more resistor elements, a second input terminal coupled to zero current circuit 210, and an output terminal providing amplified signal 206 (Vout). An LT1028 low noise bipolar op-amp is used as an example for amplifier 202, although other selections may be possible. Controlling amplifier 202 is arranged and configured to provide an inverted Vout relative to Vin in the example circuit 200 of FIG. 2.

Zero current circuit 210 may correct for two of three sources of ibias. Specifically, zero current circuit 210 may correct for AC or DC noise voltage that is present from input HI to any ground referenced circuit and/or may correct for input bias current of the bipolar amplifier 202 (a current source) which can split based on all impedances presented to the input of the amplifier 202.

Zero current circuit 210 may include at least one zero current circuit amplifier (here, two as an example) 212A, 212B. In the example of FIG. 2, zero current circuit amplifiers 212A, 212B are one ADA4620 JFET op amp and one ADI4522 zero-drift op amp, although other selections may be possible. Zero current circuit 210 may include at least one capacitor (here, one capacitor) 214 and at least one resistor (here, one resistor) 216 coupled to one another at a zero current node 218. The second input terminal of controlling amplifier 202 may also be coupled to zero current node 218. The other terminal of capacitor 214 can be coupled to ground, and the other terminal of resistor 216 can be coupled to an output of zero current circuit amplifier 212A.

Zero current circuit 210 may present zero volts across the series combination of resistor 216 and capacitor 214, or zero volts across the dielectric of capacitor 214. Zero volts across any impedance should result in zero current. At low frequencies, the total impedance may be extremely high dominated by the ceramic dielectric biased at zero. The insulation resistance of a ceramic dielectric can increase when biased at low voltages. At higher frequencies, the controlling amplifier 202 noise current can be mitigated by the resistor 216 (amplifier en/R5). The DC input bias current of controlling amplifier 202 can split between resistor 216 and capacitor 214. This may put a limit on the value of R5 for the arrangement of FIG. 2. If the lower noise bipolar controlling amplifier 202 has significant current noise at higher frequencies, this noise current may flow through capacitor 214, which may contribute to leakage.

Circuit 200 may include features that correct for two of three sources of ibias, as noted above. The third source of ibias may be an AC or DC signal voltage that is presented from input HI to any ground referenced circuit from the input signal source. The following circuits may incorporate further features to correct for the third source of ibias.

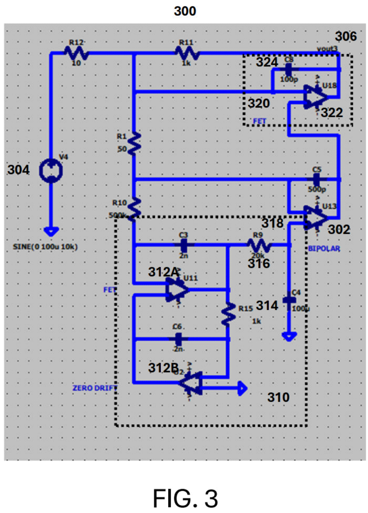

FIG. 3 shows an example circuit diagram of an inverting amplifier circuit 300 with noise and ibias reduction features including servo circuitry according to some embodiments of the disclosure. Circuit 300 may include controlling amplifier 302 having a first input terminal coupled to source 304 (Vin) through one or more resistor elements, a second input terminal coupled to zero current circuit 310, and an output terminal coupled to servo amplifier circuit 320. A bipolar op-amp (e.g., LT1028) is used as an example for amplifier 302, although other selections may be possible. Controlling amplifier 302 is arranged and configured to provide an inverted Vout relative to Vin in the example circuit 300 of FIG. 3.

Zero current circuit 310 may include at least one zero current circuit amplifier (here, two as an example) 312A, 312B. In the example of FIG. 3, zero current circuit amplifiers 312A, 312B are one JFET op amp and one zero-drift op amp, although other selections may be possible. Zero current circuit 310 may include at least one capacitor (here, one capacitor) 314 and at least one resistor (here, one resistor) 316 coupled to one another at a zero current node 318. The second input terminal of controlling amplifier 302 may also be coupled to zero current node 318. The other terminal of capacitor 314 can be coupled to ground, and the other terminal of resistor 316 can be coupled to an output of zero current circuit amplifier 312A. Zero current circuit 310 may present zero volts across the series combination of resistor 316 and capacitor 314, or zero volts across the dielectric of capacitor 314.

Zero current circuit 310 may correct for two of three sources of ibias, as described above. To address the third source of ibias noted above (the AC or DC signal voltage that is presented from input HI to any ground referenced circuit from the input signal source), circuit 300 may include servo amplifier circuit 320. Due to limited gain, the isolating large capacitance (used to obtain a very low 1/f noise corner) of zero current circuit 310 provided by capacitor 314 may see a voltage due to the input measurement. To avoid this, circuit 300 may add servo amplifier circuit 320 that may push this error voltage into single pA even for large capacitances.

For example, servo amplifier circuit 320 may include servo amplifier 322 (e.g., a JFET) and feedback 324 (e.g., a capacitor) coupling one of the inputs to servo amplifier 322 to the output of servo amplifier 322. The other input of servo amplifier 322 may be coupled to the output of controlling amplifier 302. Amplified signal 306 (Vout) may be obtained at the output of servo amplifier 322 in this arrangement. This single servo amplifier 322 may correct the noise and limited gain inaccuracies of the controlling amplifier 302 to the frequency where its closed loop bandwidth permits.

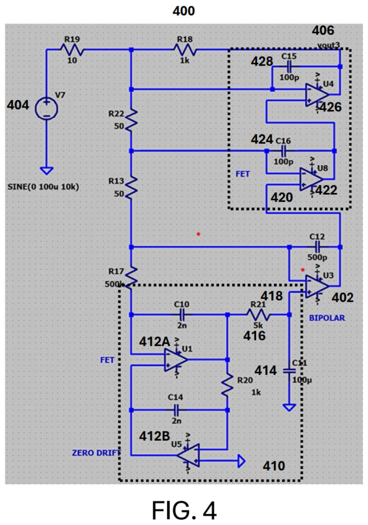

FIG. 4 shows an example circuit diagram of an inverting amplifier circuit 400 with noise and ibias reduction features including nested servo circuitry according to some embodiments of the disclosure. Circuit 400 may include controlling amplifier 402 having a first input terminal coupled to source 404 (Vin) through one or more resistor elements, a second input terminal coupled to zero current circuit 410, and an output terminal coupled to servo amplifier circuit 420. A bipolar op-amp (e.g., LT1028) is used as an example for amplifier 402, although other selections may be possible. Controlling amplifier 402 is arranged and configured to provide an inverted Vout relative to Vin in the example circuit 400 of FIG. 4.

Zero current circuit 410 may include at least one zero current circuit amplifier (here, two as an example) 412A, 412B. In the example of FIG. 4, zero current circuit amplifiers 412A, 412B are one JFET op amp and one zero-drift op amp, although other selections may be possible. Zero current circuit 410 may include at least one capacitor (here, one capacitor) 414 and at least one resistor (here, one resistor) 416 coupled to one another at a zero current node 418. The second input terminal of controlling amplifier 402 may also be coupled to zero current node 418. The other terminal of capacitor 414 can be coupled to ground, and the other terminal of resistor 416 can be coupled to an output of zero current circuit amplifier 412A. Zero current circuit 410 may present zero volts across the series combination of resistor 416 and capacitor 414, or zero volts across the dielectric of capacitor 414.

Zero current circuit 410 may correct for two of three sources of ibias, as described above. To address the third source of ibias noted above (the AC or DC signal voltage that is presented from input HI to any ground referenced circuit from the input signal source), circuit 400 may include servo amplifier circuit 420. As noted above, servo amplifier circuit 420 may push this error voltage into single pA even for large capacitances. In this example, servo amplifier circuit 420 is a nested circuit including multiple servo amplfiers.

For example, servo amplifier circuit 420 may include servo amplifier 422 (e.g., a JFET) and feedback 424 (e.g., a capacitor) coupling one of the inputs to servo amplifier 422 to the output of servo amplifier 422. The other input of servo amplifier 422 may be coupled to the output of controlling amplifier 402. Servo amplifier circuit 420 may include nesting servo amplifier 426 (e.g., a JFET) and second feedback 428 (e.g., a capacitor) coupling one of the inputs to nesting servo amplifier 426 to the output of nesting servo amplifier 426. The other input of nesting servo amplifier 426 may be coupled to the output of servo amplifier 422. Amplified signal 406 (Vout) may be obtained at the output of nesting servo amplifier 426 in this arrangement. The servo amplifier 422 and nesting servo amplifier 426 may correct the noise and limited gain inaccuracies of the controlling amplifier 402 to the frequency where its closed loop bandwidth permits.

While not shown, it should be understood that additional nesting layers may be provided (e.g., with an additional nesting servo amplifier receiving output of nesting servo amplifier 426 and having a third feedback arranged in the same fashion as in the first two servo amplifiers 422, 426, where the final Vout may be obtained from the output of the additional nesting servo amplifier. Further nesting layers may be possible as well. Each successive nesting servo amplifier may operate at a successively lower frequency than the previous servo amplifier in the nesting arrangement (e.g., the amplifier coupled to the controlling amplifier may have a highest frequency, and the amplifier from which Vout is obtained may have a lowest frequency). Whether one or more are present, servo amplifiers may be used to reduce the AC movement of the amplifiers around the grounding capacitor (e.g. capacitor 414 in this circuit). Once the "AC movement" of the signals on these capacitors approaches zero, the leakage current resulting from these signals will also approach zero. In other words, sinusoidal signals presented to the input of controlling amplifier 402 will not cause an ibias. As more nested layers of servo amplifiers are added, even larger swings of input signal may be corrected.

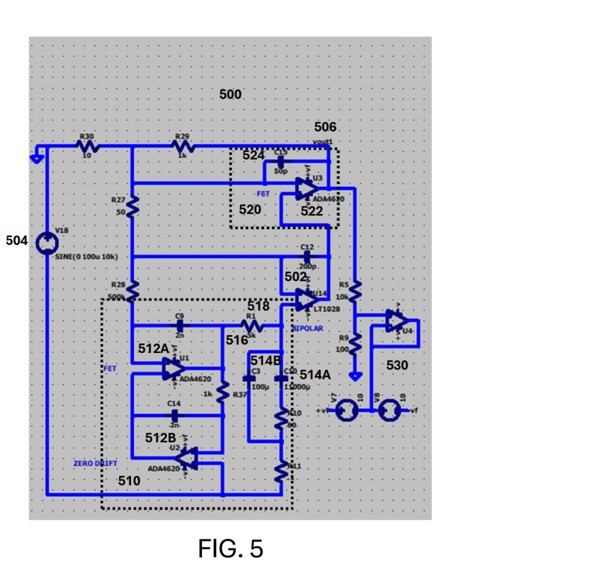

FIG. 5 shows an example circuit diagram of an amplifier circuit 500 with noise and ibias reduction features including servo circuitry according to some embodiments of the disclosure. Circuit 500 may include controlling amplifier 502 having a first input terminal coupled to source 504 (Vin) through one or more resistor elements, a second input terminal coupled to zero current circuit 510, and an output terminal coupled to servo amplifier circuit 520. A bipolar op-amp (e.g., LT1028) is used as an example for amplifier 502, although other selections may be possible. Essentially, amplifier circuit 500 is a modification of amplifier circuit 300 of FIG. 3 where controlling amplifier 502 does not invert the input signal from source 504. In some embodiments, amplifier circuit 500 may include a circuit 530 generating a +/-Vf supply to remove the common mode error.

Zero current circuit 510 may include at least one zero current circuit amplifier (here, two as an example) 512A, 512B. In the example of FIG. 5, zero current circuit amplifiers 512A, 512B are one JFET op amp and one zero-drift op amp, although other selections may be possible. Zero current circuit 510 may include at least one capacitor (here, one capacitor) 514 and at least one resistor (here, one resistor) 516 coupled to one another at a zero current node 518. The second input terminal of controlling amplifier 502 may also be coupled to zero current node 518. The other terminal of capacitor 514 can be coupled to ground, and the other terminal of resistor 516 can be coupled to an output of zero current circuit amplifier 512A. Zero current circuit 510 may present zero volts across the series combination of resistor 516 and capacitor 514, or zero volts across the dielectric of capacitor 514.

Zero current circuit 510 may correct for two of three sources of ibias, as described above. To address the third source of ibias noted above (the AC or DC signal voltage that is presented from input HI to any ground referenced circuit from the input signal source), circuit 500 may include servo amplifier circuit 520. Due to limited gain, the isolating large capacitance (used to obtain a very low 1/f noise corner) of zero current circuit 510 provided by capacitor 514 may see a voltage due to the input measurement. To avoid this, circuit 500 may add servo amplifier circuit 520 that may push this error voltage into single pA even for large capacitances.

For example, servo amplifier circuit 520 may include servo amplifier 522 (e.g., a JFET) and feedback 524 (e.g., a capacitor) coupling one of the inputs to servo amplifier 522 to the output of servo amplifier 522. The other input of servo amplifier 522 may be coupled to the output of controlling amplifier 502. Amplified signal 506 (Vout) may be obtained at the output of servo amplifier 522 in this arrangement. This single servo amplifier 522 may correct the noise and limited gain inaccuracies of the controlling amplifier 502 to the frequency where its closed loop bandwidth permits.

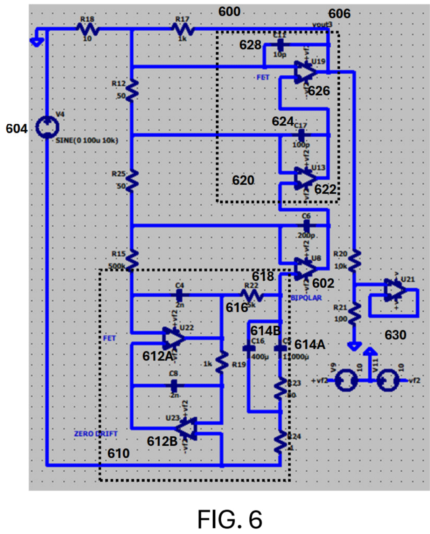

FIG. 6 shows an example circuit diagram of an amplifier circuit 600 with noise and ibias reduction features including nested servo circuitry according to some embodiments of the disclosure. Circuit 600 may include controlling amplifier 602 having a first input terminal coupled to source 604 (Vin) through one or more resistor elements, a second input terminal coupled to zero current circuit 610, and an output terminal coupled to servo amplifier circuit 620. A bipolar op-amp (e.g., LT1028) is used as an example for amplifier 602, although other selections may be possible. Essentially, amplifier circuit 600 is a modification of amplifier circuit 400 of FIG. 4 where controlling amplifier 602 does not invert the input signal from source 604. In some embodiments, amplifier circuit 600 may include a circuit 630 generating a +/-Vf supply to remove the common mode error.

Zero current circuit 610 may include at least one zero current circuit amplifier (here, two as an example) 612A, 612B. In the example of FIG. 6, zero current circuit amplifiers 612A, 612B are one JFET op amp and one zero-drift op amp, although other selections may be possible. Zero current circuit 610 may include at least one capacitor (here, one capacitor) 614 and at least one resistor (here, one resistor) 616 coupled to one another at a zero current node 618. The second input terminal of controlling amplifier 602 may also be coupled to zero current node 618. The other terminal of capacitor 614 can be coupled to ground, and the other terminal of resistor 616 can be coupled to an output of zero current circuit amplifier 612A. Zero current circuit 610 may present zero volts across the series combination of resistor 616 and capacitor 614, or zero volts across the dielectric of capacitor 614.

Zero current circuit 610 may correct for two of three sources of ibias, as described above. To address the third source of ibias noted above (the AC or DC signal voltage that is presented from input HI to any ground referenced circuit from the input signal source), circuit 600 may include servo amplifier circuit 620. As noted above, servo amplifier circuit 620 may push this error voltage into single pA even for large capacitances. In this example, servo amplifier circuit 620 is a nested circuit including multiple servo amplfiers.

For example, servo amplifier circuit 620 may include servo amplifier 622 (e.g., a JFET) and feedback 624 (e.g., a capacitor) coupling one of the inputs to servo amplifier 622 to the output of servo amplifier 622. The other input of servo amplifier 622 may be coupled to the output of controlling amplifier 602. Servo amplifier circuit 620 may include nesting servo amplifier 626 (e.g., a JFET) and second feedback 628 (e.g., a capacitor) coupling one of the inputs to nesting servo amplifier 626 to the output of nesting servo amplifier 626. The other input of nesting servo amplifier 626 may be coupled to the output of servo amplifier 622. Amplified signal 606 (Vout) may be obtained at the output of nesting servo amplifier 626 in this arrangement. The servo amplifier 622 and nesting servo amplifier 626 may correct the noise and limited gain inaccuracies of the controlling amplifier 602 to the frequency where its closed loop bandwidth permits.

While not shown, it should be understood that additional nesting layers may be provided (e.g., with an additional nesting servo amplifier receiving output of nesting servo amplifier 626 and having a third feedback arranged in the same fashion as in the first two servo amplifiers 622, 626, where the final Vout may be obtained from the output of the additional nesting servo amplifier. Further nesting layers may be possible as well. Each successive nesting servo amplifier may operate at a successively lower frequency than the previous servo amplifier in the nesting arrangement (e.g., the amplifier coupled to the controlling amplifier may have a highest frequency, and the amplifier from which Vout is obtained may have a lowest frequency). Whether one or more are present, servo amplifiers may be used to reduce the AC movement of the amplifiers around the grounding capacitor (e.g. capacitor 614 in this circuit). Once the "AC movement" of the signals on these capacitors approaches zero, the leakage current resulting from these signals will also approach zero. In other words, sinusoidal signals presented to the input of controlling amplifier 602 will not cause an ibias. As more nested layers of servo amplifiers are added, even larger swings of input signal may be corrected.

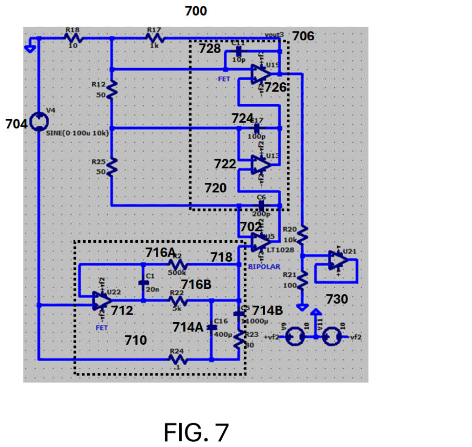

The examples of FIGS. 7-9 are alternative arrangements of circuit 600 of FIG. 6 wherein the zero current circuit is configured differently. The DC input bias current of the controlling amplifier will split between the resistor and capacitor of the zero current circuit, which may put a limit on the value of the resistor. If the lower noise bipolar has significant current noise at higher frequencies, this noise current will flow through the capacitor, which may contribute to leakage. The circuits of FIGS. 7-9 may mitigate this noise for lower frequencies.

FIG. 7 shows an example circuit diagram of an amplifier circuit 700 with noise and ibias reduction features including nested servo circuitry according to some embodiments of the disclosure. Circuit 700 may include controlling amplifier 702 having a first input terminal coupled to source 704 (Vin) through one or more resistor elements, a second input terminal coupled to zero current circuit 710, and an output terminal coupled to servo amplifier circuit 720. A bipolar op-amp (e.g., LT1028) is used as an example for amplifier 702, although other selections may be possible. In some embodiments, amplifier circuit 700 may include a circuit 730 generating a +/-Vf supply to remove the common mode error.

Zero current circuit 710 may include at least one zero current circuit amplifier 712. In the example of FIG. 7, zero current circuit amplifier 712 is a JFET op amp, although other selections may be possible. Zero current circuit 710 may include at least one capacitor (here, two capacitors) 714A, 714B and at least one resistor (here, two resistors) 716A, 716B coupled to one another at a zero current node 718. The second input terminal of controlling amplifier 702 may also be coupled to zero current node 718. Zero current circuit 710 may present zero volts across the dielectrics of capacitors 714A, 714B.

Zero current circuit 710 may correct for two of three sources of ibias, as described above. To address the third source of ibias noted above (the AC or DC signal voltage that is presented from input HI to any ground referenced circuit from the input signal source), circuit 700 may include servo amplifier circuit 720. As noted above, servo amplifier circuit 720 may push this error voltage into single pA even for large capacitances. In this example, servo amplifier circuit 720 is a nested circuit including multiple servo amplfiers.

For example, servo amplifier circuit 720 may include servo amplifier 722 (e.g., a JFET) and feedback 724 (e.g., a capacitor) coupling one of the inputs to servo amplifier 722 to the output of servo amplifier 722. The other input of servo amplifier 722 may be coupled to the output of controlling amplifier 702. Servo amplifier circuit 720 may include nesting servo amplifier 726 (e.g., a JFET) and second feedback 728 (e.g., a capacitor) coupling one of the inputs to nesting servo amplifier 726 to the output of nesting servo amplifier 726. The other input of nesting servo amplifier 726 may be coupled to the output of servo amplifier 722. Amplified signal 706 (Vout) may be obtained at the output of nesting servo amplifier 726 in this arrangement. The servo amplifier 722 and nesting servo amplifier 726 may correct the noise and limited gain inaccuracies of the controlling amplifier 702 to the frequency where its closed loop bandwidth permits.

While not shown, it should be understood that additional nesting layers may be provided (e.g., with an additional nesting servo amplifier receiving output of nesting servo amplifier 726 and having a third feedback arranged in the same fashion as in the first two servo amplifiers 722, 726, where the final Vout may be obtained from the output of the additional nesting servo amplifier. Further nesting layers may be possible as well. Each successive nesting servo amplifier may operate at a successively lower frequency than the previous servo amplifier in the nesting arrangement (e.g., the amplifier coupled to the controlling amplifier may have a highest frequency, and the amplifier from which Vout is obtained may have a lowest frequency). Whether one or more are present, servo amplifiers may be used to reduce the AC movement of the amplifiers around the grounding capacitor (e.g. capacitor 714 in this circuit). Once the "AC movement" of the signals on these capacitors approaches zero, the leakage current resulting from these signals will also approach zero. In other words, sinusoidal signals presented to the input of controlling amplifier 702 will not cause an ibias. As more nested layers of servo amplifiers are added, even larger swings of input signal may be corrected.

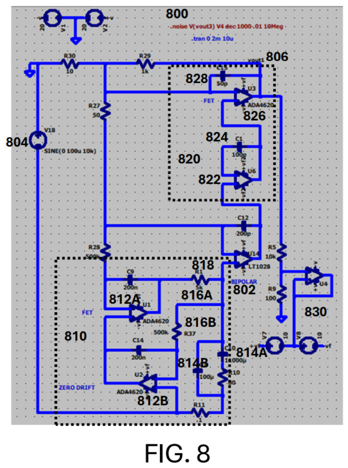

FIG. 8 shows an example circuit diagram of an amplifier circuit 800 with noise and ibias reduction features including nested servo circuitry according to some embodiments of the disclosure. Circuit 800 may include controlling amplifier 802 having a first input terminal coupled to source 804 (Vin) through one or more resistor elements, a second input terminal coupled to zero current circuit 810, and an output terminal coupled to servo amplifier circuit 820. A bipolar op-amp (e.g., LT1028) is used as an example for amplifier 802, although other selections may be possible. In some embodiments, amplifier circuit 800 may include a circuit 830 generating a +/-Vf supply to remove the common mode error.

Zero current circuit 810 may include at least one zero current circuit amplifier (here, two amplifiers) 812A, 812B. In the example of FIG. 8, zero current circuit amplifier 812A is a JFET op amp, and zero current circuit amplifier 812B is a zero drift op amp, although other selections may be possible. Zero current circuit 810 may include at least one capacitor (here, two capacitors) 814A, 814B and at least one resistor (here, two resistors) 816A, 816B coupled to one another at a zero current node 818. The second input terminal of controlling amplifier 802 may also be coupled to zero current node 818. Zero current circuit 810 may present zero volts across the dielectrics of capacitors 814A, 814B.

Zero current circuit 810 may correct for two of three sources of ibias, as described above. To address the third source of ibias noted above (the AC or DC signal voltage that is presented from input HI to any ground referenced circuit from the input signal source), circuit 800 may include servo amplifier circuit 820. As noted above, servo amplifier circuit 820 may push this error voltage into single pA even for large capacitances. In this example, servo amplifier circuit 820 is a nested circuit including multiple servo amplfiers.

For example, servo amplifier circuit 820 may include servo amplifier 822 (e.g., a JFET) and feedback 824 (e.g., a capacitor) coupling one of the inputs to servo amplifier 822 to the output of servo amplifier 822. The other input of servo amplifier 822 may be coupled to the output of controlling amplifier 802. Servo amplifier circuit 820 may include nesting servo amplifier 826 (e.g., a JFET) and second feedback 828 (e.g., a capacitor) coupling one of the inputs to nesting servo amplifier 826 to the output of nesting servo amplifier 826. The other input of nesting servo amplifier 826 may be coupled to the output of servo amplifier 822. Amplified signal 806 (Vout) may be obtained at the output of nesting servo amplifier 826 in this arrangement. The servo amplifier 822 and nesting servo amplifier 826 may correct the noise and limited gain inaccuracies of the controlling amplifier 802 to the frequency where its closed loop bandwidth permits.

While not shown, it should be understood that additional nesting layers may be provided (e.g., with an additional nesting servo amplifier receiving output of nesting servo amplifier 826 and having a third feedback arranged in the same fashion as in the first two servo amplifiers 822, 826, where the final Vout may be obtained from the output of the additional nesting servo amplifier. Further nesting layers may be possible as well. Each successive nesting servo amplifier may operate at a successively lower frequency than the previous servo amplifier in the nesting arrangement (e.g., the amplifier coupled to the controlling amplifier may have a highest frequency, and the amplifier from which Vout is obtained may have a lowest frequency). Whether one or more are present, servo amplifiers may be used to reduce the AC movement of the amplifiers around the grounding capacitor (e.g. capacitor 814 in this circuit). Once the "AC movement" of the signals on these capacitors approaches zero, the leakage current resulting from these signals will also approach zero. In other words, sinusoidal signals presented to the input of controlling amplifier 802 will not cause an ibias. As more nested layers of servo amplifiers are added, even larger swings of input signal may be corrected.

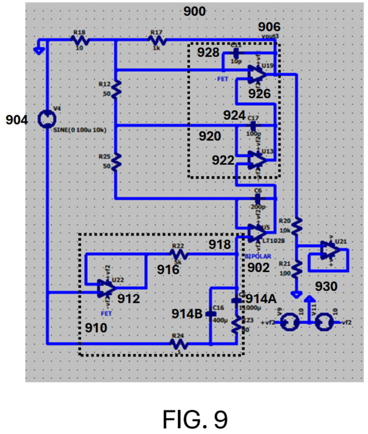

FIG. 9 shows an example circuit diagram of an amplifier circuit 900 with noise and ibias reduction features including nested servo circuitry according to some embodiments of the disclosure. Circuit 900 may include controlling amplifier 902 having a first input terminal coupled to source 904 (Vin) through one or more resistor elements, a second input terminal coupled to zero current circuit 910, and an output terminal coupled to servo amplifier circuit 920. A bipolar op-amp (e.g., LT1028) is used as an example for amplifier 902, although other selections may be possible. In some embodiments, amplifier circuit 900 may include a circuit 930 generating a +/-Vf supply to remove the common mode error.

Zero current circuit 910 may include at least one zero current circuit amplifier 912. In the example of FIG. 9, zero current circuit amplifier 912 is a JFET op amp, although other selections may be possible. Zero current circuit 910 may include at least one capacitor (here, two capacitors) 914A, 914B and at least one resistor 916 coupled to one another at a zero current node 918. The second input terminal of controlling amplifier 902 may also be coupled to zero current node 918. Zero current circuit 910 may present zero volts across the dielectrics of capacitors 914A, 914B.

Zero current circuit 910 may correct for two of three sources of ibias, as described above. To address the third source of ibias noted above (the AC or DC signal voltage that is presented from input HI to any ground referenced circuit from the input signal source), circuit 900 may include servo amplifier circuit 920. As noted above, servo amplifier circuit 920 may push this error voltage into single pA even for large capacitances. In this example, servo amplifier circuit 920 is a nested circuit including multiple servo amplifiers.

For example, servo amplifier circuit 920 may include servo amplifier 922 (e.g., a JFET) and feedback 924 (e.g., a capacitor) coupling one of the inputs to servo amplifier 922 to the output of servo amplifier 922. The other input of servo amplifier 922 may be coupled to the output of controlling amplifier 902. Servo amplifier circuit 920 may include nesting servo amplifier 926 (e.g., a JFET) and second feedback 928 (e.g., a capacitor) coupling one of the inputs to nesting servo amplifier 926 to the output of nesting servo amplifier 926. The other input of nesting servo amplifier 926 may be coupled to the output of servo amplifier 922. Amplified signal 906 (Vout) may be obtained at the output of nesting servo amplifier 926 in this arrangement. The servo amplifier 922 and nesting servo amplifier 926 may correct the noise and limited gain inaccuracies of the controlling amplifier 902 to the frequency where its closed loop bandwidth permits.

While not shown, it should be understood that additional nesting layers may be provided (e.g., with an additional nesting servo amplifier receiving output of nesting servo amplifier 926 and having a third feedback arranged in the same fashion as in the first two servo amplifiers 922, 926, where the final Vout may be obtained from the output of the additional nesting servo amplifier. Further nesting layers may be possible as well. Each successive nesting servo amplifier may operate at a successively lower frequency than the previous servo amplifier in the nesting arrangement (e.g., the amplifier coupled to the controlling amplifier may have a highest frequency, and the amplifier from which Vout is obtained may have a lowest frequency). Whether one or more are present, servo amplifiers may be used to reduce the AC movement of the amplifiers around the grounding capacitor (e.g. capacitor 914 in this circuit). Once the "AC movement" of the signals on these capacitors approaches zero, the leakage current resulting from these signals will also approach zero. In other words, sinusoidal signals presented to the input of controlling amplifier 902 will not cause an ibias. As more nested layers of servo amplifiers are added, even larger swings of input signal may be corrected.

In summary, circuits 600, 700, 800, and 900 of FIGS. 6-9 may attenuate the input measurement (such as the AC stimulus from a Lock-in amplifier) from the input capacitance, force zero across either the input capacitance or the series combination of the input capacitance and the JFET amplifier output resistance, and provide a low enough impedance to the JFET amplifier that a negligible amount of the low noise bipolar amplfier's ibias is leakage. The general technique pursued in the new arrangement begins with the lowest noise bipolar to be found, then lowers the unacceptable ibias of the low noise bipolar amplifier with the described circuit arrangement.

The following figures show examples demonstrating noise performance of some of the above circuits in a test environment. These examples are included to demonstrate possible noise characteristics and are not necessarily limiting to the performance of any example circuits or variations thereof. The examples show noise performance for circuits 600, 700, 800, and 900 each having a gain of 100. Each of these figures clearly show bipolar level noise performance.

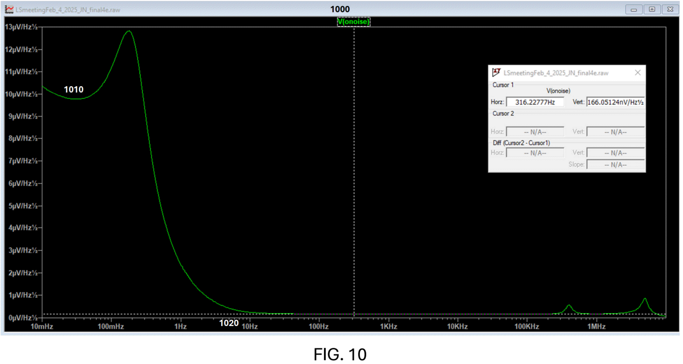

FIG. 10 shows an example noise curve for the circuit 700 of FIG. 7 according to some embodiments of the disclosure. As shown, the noise 1010 (e.g., at the input of controlling amplifier 702) may be <13µV/Hz(1/2) with a corner frequency 1020 of <10Hz.

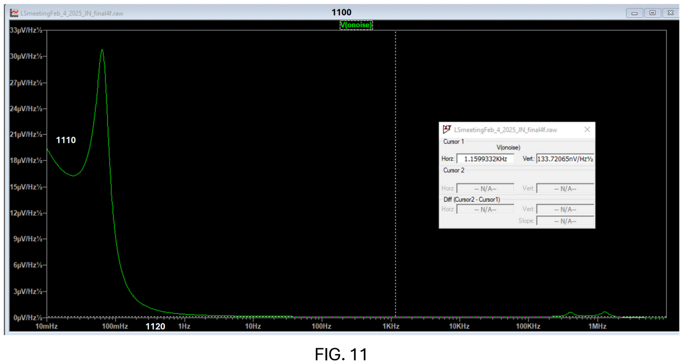

FIG. 11 shows an example noise curve for the circuit 800 of FIG. 8 according to some embodiments of the disclosure. As shown, the noise 1110 (e.g., at the input of controlling amplifier 802) may be <33µV/Hz(1/2) with a corner frequency 1120 of <1Hz.

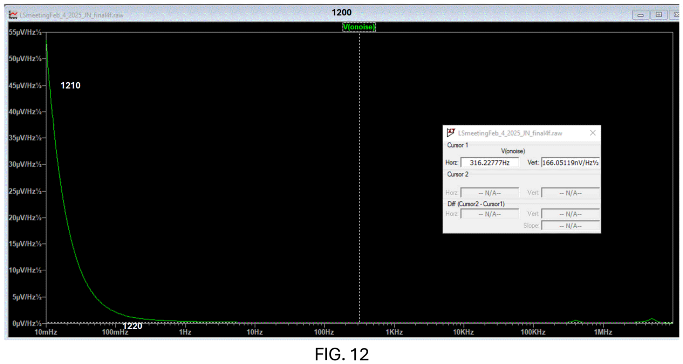

FIG. 12 shows an example noise curve for the circuit 900 of FIG. 9 according to some embodiments of the disclosure. As shown, the noise 1210 (e.g., at the input of controlling amplifier 902) may be <55µV/Hz(1/2) with a corner frequency 1020 of <100mHz.

While various embodiments have been described above, it should be understood that they have been presented by way of example and not limitation. It will be apparent to persons skilled in the relevant art(s) that various changes in form and detail can be made therein without departing from the spirit and scope. In fact, after reading the above description, it will be apparent to one skilled in the relevant art(s) how to implement alternative embodiments. For example, other steps may be provided, or steps may be eliminated, from the described flows, and other components may be added to, or removed from, the described systems. Accordingly, other implementations are within the scope of the following claims.

In addition, it should be understood that any figures which highlight the functionality and advantages are presented for example purposes only. The disclosed methodology and system are each sufficiently flexible and configurable such that they may be utilized in ways other than that shown.

Although the term "at least one" may often be used in the specification, claims and drawings, the terms "a", "an", "the", "said", etc. also signify "at least one" or "the at least one" in the specification, claims and drawings.

Finally, it is the applicant's intent that only claims that include the express language "means for" or "step for" be interpreted under 35 U.S.C. 112(f). Claims that do not expressly include the phrase "means for" or "step for" are not to be interpreted under 35 U.S.C. 112(f).

## Claims

1. A circuit comprising:
a controlling amplifier configured to produce an amplified signal from an input signal, the controlling amplifier comprising a first controlling amplifier input terminal configured to receive the input signal, a second controlling amplifier input terminal coupled to a zero current node, and a controlling amplifier output terminal configured to output the amplified signal;
a zero current circuit coupled to the zero current node, the zero current circuit comprising at least one capacitor comprising a first terminal coupled to the zero current node, the zero current circuit configured to force voltages across each at least one capacitor to zero; and
a servo amplifier circuit comprising a servo amplifier and a feedback, the servo amplifier comprising a first servo amplifier input terminal coupled to the controlling amplifier output terminal, a second servo amplifier input terminal, and a servo amplifier output terminal, wherein the feedback is coupled to the second servo amplifier input terminal and the servo amplifier output terminal.

2. The circuit of claim 1, wherein the servo amplifier comprises a field effect transistor amplifier.

3. The circuit of claim 1 or 2, wherein the servo amplifier circuit further comprises a nesting servo amplifier and a second feedback, the nesting servo amplifier comprising a first nesting servo amplifier input terminal coupled to the servo amplifier output terminal, a second nesting servo amplifier input terminal, and a nesting servo amplifier output terminal, wherein the second feedback is coupled to the second nesting servo amplifier input terminal and the nesting servo amplifier output terminal.

4. The circuit of claim 3, wherein the nesting servo amplifier comprises a field effect transistor amplifier.

5. The circuit of claim 3 or 4, wherein the servo amplifier operates at a first frequency and the nesting servo amplifier operates at a second frequency lower than the first frequency.

6. The circuit of any of claims 3 to 5, wherein the servo amplifier circuit further comprises an additional nesting servo amplifier and a third feedback, the additional nesting servo amplifier comprising a first additional nesting servo amplifier input terminal coupled to the nesting servo amplifier output terminal, a second additional nesting servo amplifier input terminal, and an additional nesting servo amplifier output terminal, wherein the third feedback is coupled to the second additional nesting servo amplifier input terminal and the additional nesting servo amplifier output terminal.

7. The circuit of claim 6, wherein the additional nesting servo amplifier comprises a field effect transistor amplifier.

8. The circuit of claim 6 or 7, wherein the servo amplifier operates at a first frequency, the nesting servo amplifier operates at a second frequency lower than the first frequency, and the additional nesting servo amplifier operates at a third frequency lower than the second frequency.

9. A circuit comprising:
a controlling amplifier configured to produce an amplified signal from an input signal, the controlling amplifier comprising a first controlling amplifier input terminal configured to receive the input signal, a second controlling amplifier input terminal coupled to a zero current node, and a controlling amplifier output terminal configured to output the amplified signal; and
a zero current circuit coupled to the zero current node, the zero current circuit comprising at least one capacitor comprising a first terminal coupled to the zero current node, the zero current circuit configured to force voltages across each at least one capacitor to zero.

10. The circuit of any of claims 1 to 9, wherein the zero current circuit further comprises at least one resistor comprising a first terminal coupled to the zero current node.

11. The circuit of claim 10, wherein the zero current circuit further comprises a zero current circuit amplifier comprising a zero current circuit amplifier output coupled to a second terminal of the at least one resistor and configured to present zero volts across a series combination of the at least one resistor and the at least one capacitor.

12. The circuit of claim 11, wherein the zero current circuit amplifier comprises a field effect transistor amplifier.

13. The circuit of any of claims 10 to 12, wherein a resistance of the at least one resistor and a capacitance of the at least one capacitor are selected to provide a current path away from the zero current node through the at least one resistor for at least one frequency of the input signal.

14. The circuit of any of claims 1 to 13, wherein the controlling amplifier comprises a bipolar amplifier.

15. A circuit comprising:
a controlling amplifier configured to produce an amplified signal from an input signal, the controlling amplifier comprising a first controlling amplifier input terminal configured to receive the input signal, a second controlling amplifier input terminal coupled to a zero current node, and a controlling amplifier output terminal configured to output the amplified signal, wherein the controlling amplifier comprises a bipolar amplifier;
a zero current circuit coupled to the zero current node, the zero current circuit configured to force voltages across each at least one capacitor to zero, the zero current circuit comprising:
at least one capacitor comprising a first terminal coupled to the zero current node,
at least one resistor comprising a first terminal coupled to the zero current node, and
a zero current circuit amplifier comprising a zero current circuit amplifier output coupled to a second terminal of the at least one resistor and configured to present zero volts across a series combination of the at least one resistor and the at least one capacitor, wherein the zero current circuit amplifier comprises a field effect transistor amplifier, and wherein a resistance of the at least one resistor and a capacitance of the at least one capacitor are selected to provide a current path away from the zero current node through the at least one resistor for at least one frequency of the input signal; and
a servo amplifier circuit comprising:
a servo amplifier and a feedback, the servo amplifier comprising a first servo amplifier input terminal coupled to the controlling amplifier output terminal, a second servo amplifier input terminal, and a servo amplifier output terminal, wherein the servo amplifier comprises a field effect transistor amplifier, and wherein the feedback is coupled to the second servo amplifier input terminal and the servo amplifier output terminal,
a nesting servo amplifier and a second feedback, the nesting servo amplifier comprising a first nesting servo amplifier input terminal coupled to the servo amplifier output terminal, a second nesting servo amplifier input terminal, and a nesting servo amplifier output terminal, wherein the nesting servo amplifier comprises a field effect transistor amplifier, and wherein the second feedback is coupled to the second nesting servo amplifier input terminal and the nesting servo amplifier output terminal, and
an additional nesting servo amplifier and a third feedback, the additional nesting servo amplifier comprising a first additional nesting servo amplifier input terminal coupled to the nesting servo amplifier output terminal, a second additional nesting servo amplifier input terminal, and an additional nesting servo amplifier output terminal, wherein the additional nesting servo amplifier comprises a field effect transistor amplifier, and wherein the third feedback is coupled to the second additional nesting servo amplifier input terminal and the additional nesting servo amplifier output terminal,
wherein the servo amplifier operates at a first frequency, the nesting servo amplifier operates at a second frequency lower than the first frequency, and the additional nesting servo amplifier operates at a third frequency lower than the second frequency.
